# EUROPEAN PATENT SPECIFICATION

(11) **EP 3 778 805 B1**
(45) Date of publication and mention of the grant of the patent: **03.09.2025**
(21) Application number: 19778185.9
(22) Date of filing: 26.03.2019
(51) Int. Cl.: C09D 11/38, B41M 5/00, H05K 3/28, C09D 11/101, H05K 3/34

(54) **CURABLE COMPOSITION FOR INKJET, CURED PRODUCT OF SAME, AND ELECTRONIC COMPONENT COMPRISING SAID CURED PRODUCT**
HÄRTBARE ZUSAMMENSETZUNG FÜR TINTENSTRAHL, GEHÄRTETES PRODUKT DARAUS UND ELEKTRONISCHES BAUTEIL MIT DIESEM GEHÄRTETEN PRODUKT
COMPOSITION DURCISSABLE POUR JET D'ENCRE, PRODUIT DURCI DE CELLE-CI, ET COMPOSANT ÉLECTRONIQUE COMPRENANT LEDIT PRODUIT DURCI

(30) Priority: 30.03.2018 JP 2018069133
(43) Date of publication of application: 17.02.2021
(73) Proprietor: TAIYO HOLDINGS CO., LTD., Saitama 355-0222 (JP)
(72) Inventor: ITO, Hideyuki, Hiki-gun, Saitama 355-0215 (JP); SHIMURA, Masayuki, Hiki-gun, Saitama 355-0215 (JP); MATSUMOTO, Hiroshi, Hiki-gun, Saitama 355-0215 (JP); WEI, Xiaozhu, Hiki-gun, Saitama 355-0215 (JP); YOSHIKAWA, Rina, Hiki-gun, Saitama 355-0215 (JP)
(74) Representative: Hoffmann Eitle
(86) International application number: PCT/JP2019/012857
(87) International publication number: WO 2019/189185

(56) References cited:
- EP-A1- 3 067 374
- WO-A1-2017/052351
- WO-A1-2017/145671
- WO-A2-2007/022226
- JP-A- 2008 545 859
- JP-A- 2015 028 131
- JP-A- 2017 009 715
- JP-A- 2017 215 569
- JP-A- H07 109 322
- US-A1- 2012 083 545

## Description

### Technical Field

The present invention relates to a curable composition for inkjet, and in particular, relates to a curable composition for inkjet which has an excellent curing performance at surface point and an excellent curing performance at deep point, a cured product of same, and an electronic component having the cured product.

### Background Art

A photographic developing method and a screen-printing method have so far been used to form an etching resist, a solder resist, and a marking on a printed wiring board. In recent years, an inkjet method is also used to simplify patterning.

Patent document 1 discloses a photocurable and thermosetting composition which is used in inkjet printing. This composition contains a (meth)acryloyl group-containing monomer, block isocyanate, and a photopolymerization initiator. The formulation of the composition leads to the composition having a relatively low viscosity suitable for an inkjet method. Further, the formulation improves adhesion, heat resistance and the like of a cured composition after the composition is cured.

### Prior Art Literature

### Patent Literature

Patent document 1
WO 2013/146706

### Summary of Invention

### Problems to be solved by the Invention

Conventional curable compositions for inkjet are (ink-type) curable compositions which are made to have a low viscosity in order to be able to discharge the curable compositions from inkjet printers. Thus, a problem thereof lies in that oxygen in air easily dissolves and diffuses in the curable compositions. Further, in the inkjet printing method, curable compositions are discharged as small droplets, and as a result, the specific surface area of the whole curable compositions discharged as droplets becomes large. That is, a larger amount of oxygen easily dissolves therein.

For these reasons, the compositions are susceptible to so-called oxygen inhibition. That is, the curing of the compositions is hindered by oxygen in air when the compositions are cured with ultraviolet light after inkjet printing. Thus, a curing performance at surface point of the cured film is easily lowered, and bleeding easily occurs. Further, curable compositions for inkjet printing have been required to further improve not only a curing performance at surface point but also a curing performance at deep point.

Accordingly, an object of the present invention is to provide a curable composition for inkjet printing that has an excellent curing performance at surface point and an excellent curing performance at deep point.

Further, another object of the present invention is to provide a cured product obtained by curing the curable composition for inkjet printing, and an electronic component having the cured product.

### Means for Solving the Problem

The above object is achieved by a curable composition for inkjet which contains (A) an oxime ester-based photopolymerization initiator; (B) an amino group-containing (meth)acrylate compound; an aminoacetophenone-based photopolymerization initiator; a hydroxyl group-containing (meth)acrylate; and a block isocyanate compound, wherein said (A) oxime ester-based photopolymerization initiator is an oxime ester compound having a carbazole structure represented by the following general formula (I): 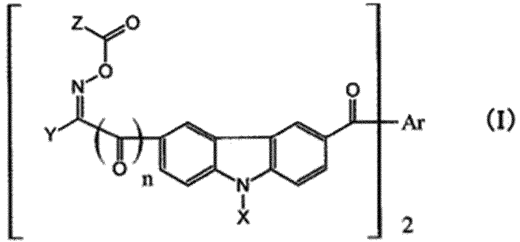
wherein X represents a hydrogen atom, an alkyl group having 1 to 17 carbon atoms, an alkoxy group having 1 to 8 carbon atoms, a phenyl group which may have a substituent selected from an alkyl group having 1 to 17 carbon atoms, an alkoxy group having 1 to 8 carbon atoms, an amino group, and an alkylamino or dialkylamino group in which the alkyl moiety has 1 to 8 carbon atoms, or a naphthyl group which may have a substituent selected from an alkyl group having 1 to 17 carbon atoms, an alkoxy group having 1 to 8 carbon atoms, an amino group, and an alkylamino group or dialkylamino group in which the alkyl moiety has 1 to 8 carbon atoms;
each of the Y and Z represents a hydrogen atom, an alkyl group having 1 to 17 carbon atoms, an alkoxy group having 1 to 8 carbon atoms, a halogen group, a phenyl group which may have a substituent selected from an alkyl group having 1 to 17 carbon atoms, an alkoxy group having 1 to 8 carbon atoms, an amino group, and an alkylamino or dialkylamino group in which the alkyl moiety has 1 to 8 carbon atoms, a naphthyl group which may have a substituent selected from an alkyl group having 1 to 17 carbon atoms, an alkoxy group having 1 to 8 carbon atoms, an amino group, and an alkylamino or dialkylamino group in which the alkyl moiety has 1 to 8 carbon atoms, an anthryl group, a pyridyl group, a benzofuryl group, or a benzothienyl group;
Ar represents alkylene having 1 to 10 carbon atoms, vinylene, phenylene, biphenylene, pyridylene, naphthylene, thiophene, anthrylene, thienylene, furylene, 2,5-pyrrol-diyl, 4,4'-stilben-diyl, or
4,2'-styren-diyl; and
n is an integer of 0 or 1.

Oxime ester-based photopolymerization initiators so far have not been used because their initiators cause oxygen inhibition (concretely, the generation of bleeding, and the decrease in tackiness) and thereby a curing performance at surface point is lowered. However, the present inventors have found that the use of both the oxime ester-based photopolymerization initiator and an amino group-containing (meth) acrylate compound can provide an excellent curing performance at surface point, and that the use of an oxime ester photopolymerization initiator can improve a curing performance at deep point and solder heat resistance.

Further, the above object is achieved by a cured product obtained by curing the curable composition for inkjet printing of the present invention, and an electronic component having the cured product.

### Effects of Invention

According to the present invention, a curable composition for inkjet printing that has an excellent curing performance at surface point and an excellent curing performance at deep point can be provided.

### Mode for carrying out the Invention

The present invention will be described in detail below. As described above, the curable composition for inkjet printing of the present invention contains an amino group-containing (meth)acrylate and an oxime ester-based photopolymerization initiator. The "(meth)acrylate", which is used herein and in claims, is a collective term for acrylate, methacrylate, and a mixture thereof. This also applies to other similar expressions.

### <(B) Amino group-containing (meth)acrylate>

The amino group-containing (meth)acrylate is a compound having at least one amino group and at least one acryloyl group or methacryloyl group. The amino group may be any of a primary amino group, a secondary amino group, and a tertiary amino group. Concrete examples of the amino group-containing (meth)acrylate include aminomethyl (meth)acrylate, aminoethyl (meth)acrylate, aminopropyl (meth)acrylate, aminobutyl (meth)acrylate, and amine-modified polyester acrylate. One of them may be used alone, or two or more thereof may be used in combination. Examples of commercially available products include DM-281 (amine-modified polyfunctional polyester acrylate) manufactured by DOUBLE BOND CHEMICAL IND. CO., LTD., and CN371NS (bifunctional amino acrylate) manufactured by ARKEMA.

The content of the amino group-containing (meth)acrylate is, for example, 1 to 100% by mass, preferably 1 to 50% by mass, more preferably 1 to 20% by mass, even more preferably 1 to 10% by mass, particularly preferably 2 to 8% by mass, and most preferably 3 to 7% by mass based on the total mass weight of the (meth) acryloyl group-containing monomer contained in the composition of the present invention.

The "(meth) acryloyl group-containing monomer", which is used herein, means a (meth) acryloyl group-containing compound which is contained in the curable composition for inkjet of the present invention. The "(meth)acryloyl group-containing monomer" encompasses hydroxyl group-containing (meth)acrylate, monofunctional (meth)acrylate, and bifunctional (meth) acrylate as mentioned below, in addition to the amino group-containing (meth)acrylate.

### <(A) Oxime ester-based photopolymerization initiator>

The oxime ester-based photopolymerization initiator is an oxime ester compound having a carbazole structure represented by the following general formula (I). 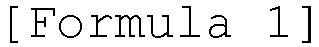 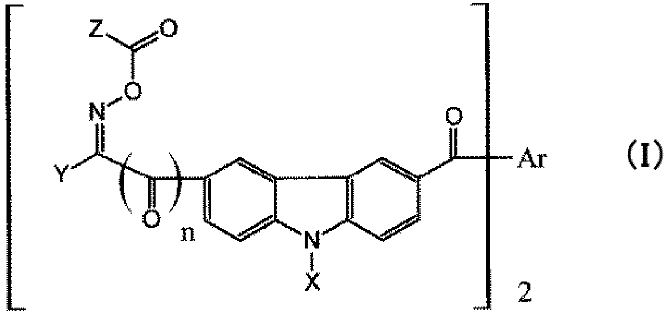
wherein X represents a hydrogen atom, an alkyl group having 1 to 17 carbon atoms, an alkoxy group having 1 to 8 carbon atoms, a phenyl group (which may have substituent selected from an alkyl group having 1 to 17 carbon atoms, an alkoxy group having 1 to 8 carbon atoms, an amino group, and, an alkylamino or dialkylamino group in which the alkyl moiety has 1 to 8 carbon atoms), or a naphthyl group (which may have substituent selected from an alkyl group having 1 to 17 carbon atoms, an alkoxy group having 1 to 8 carbon atoms, an amino group, or, an alkylamino group or dialkylamino group in which the alkyl moiety has 1 to 8 carbon atoms) ;
each of the Y and Z represents a hydrogen atom, an alkyl group having 1 to 17 carbon atoms, an alkoxy group having 1 to 8 carbon atoms, a halogen group, a phenyl group (which may have substituent selected from an alkyl group having 1 to 17 carbon atoms, an alkoxy group having 1 to 8 carbon atoms, or an amino group, or, an alkylamino or dialkylamino group in which the alkyl moiety has 1 to 8 carbon atoms), a naphthyl group (which may have substituent selected from an alkyl group having 1 to 17 carbon atoms, an alkoxy group having 1 to 8 carbon atoms, an amino group, or, an alkylamino or dialkylamino group in which the alkyl moiety has 1 to 8 carbon atoms), an anthryl group, a pyridyl group, a benzofuryl group, or a benzothienyl group;
Ar represents alkylene having 1 to 10 carbon atoms, vinylene, phenylene, biphenylene, pyridylene, naphthylene, thiophene, anthrylene, thienylene, furylene, 2,5-pyrrol-diyl, 4,4'-stilben-diyl, or 4,2'-styren-diyl; and
n is an integer of 0 or 1.

In particular, preferable is an oxime ester-based photopolymerization initiator represented by the above formula wherein each of the X and Y are a methyl group or an ethyl group, Z is methyl or phenyl, n is 0, and Ar is phenylene, naphthylene, thiophene, or thienylene.

The amount blended of the oxime ester-based photopolymerization initiator is usually 0.01 to 5 parts by mass, preferably 0.05 to 4 parts by mass, more preferably 0.1 to 3 parts by mass, and particularly preferably 0.5 to 2 parts by mass with respect to 100 parts by mass of the (meth)acryloyl group-containing monomer.

### <Aminoacetophenone-based photopolymerization initiator>

The curable composition for inkjet of the present invention contains an aminoacetophenone-based photopolymerization initiator. This further improves both a curing performance at surface point and a curing performance at deep point. Concrete examples of the aminoacetophenone-based photopolymerization initiator include benzyl-2-dimethylamino-1-(4-morpholinophenyl)-butanone, 2-methyl-1-[4-(methylthio)phenyl]-2-morpholinopropanone-1,2-benzyl-2-dimethylamino-1-(4-morpholinophenyl)-butan-1-one, 2-(dimethylamino)-2-[(4-methylphenyl)methyl]-1-[4-(4-morpholinyl)ph enyl]-1-butanone, and N,N-dimethylaminoacetophenone. Examples of commercially available products include Omnirad 379, 379, and 907 manufactured by IGM. One of them may be used alone, or two or more thereof may be used in combination.

The amount blended of the aminoacetophenone-based photopolymerization initiator is usually 0.1 to 15 parts by mass, preferably 1 to 12 parts by mass, and more preferably 2 to 10 parts by mass with respect to 100 parts by mass of the (meth)acryloyl group-containing monomer contained in the curable composition of the present invention.

Preferably, the mass ratio of the aminoacetophenone-based photopolymerization initiator to the oxime ester-based photopolymerization initiator (the aminoacetophenone-based photopolymerization initiator/the oxime ester-based photopolymerization initiator ratio) is for example 1 to 30, preferably 5 to 20, in order to further improve the effects of the present invention.

### (Other photopolymerization initiators)

The curable composition for inkjet of the present invention may contain other photopolymerization initiator(s) other than the above initiator(s). Examples of other radical photopolymerization initiator(s) include benzoin and benzoin alkyl ethers(for example, benzoin, benzoin methyl ether, benzoin ethyl ether, and benzoin isopropyl ether); acetophenones (for example, acetophenone, 2,2-dimethoxy-2-phenylacetophenone, 2,2-diethoxy-2-phenylacetophenone, and 1,1-dichloroacetophenone); anthraquinones (for example, 2-methylanthraquinone, 2-ethylanthraquinone, 2-t-butylanthraquinone, and 1-chloroanthraquinone); thioxanthones (for example, 2,4-dimethylthioxanthone, 2,4-diethylthioxanthone, 2-chlorothioxanthone, and 2,4-diisopropylthioxanthone); ketals (for example, acetophenone dimethyl ketal and benzyl dimethyl ketal); a 2,4,5-triarylimidazole dimer; riboflavin tetrabutyrate; thiol compounds (for example, 2-mercaptobenzimidazole, 2-mercaptobenzoxazole, and 2-mercaptobenzothiazole); organohalogen compounds (for example, 2,2,2-tribromoethanol, and tribromomethyl phenyl sulfone); benzophenones (for example, benzophenone and 4,4'-bisdiethylaminobenzophenone, or xanthones); and 2,4,6-trimethylbenzoyldiphenylphosphine oxide.

In addition to them, photoinitiator aids (for example, tertiary amines such as N, N-dimethylaminobenzoic acid ethyl ester, N, N-dimethylaminobenzoic acid isoamyl ester, pentyl-4-dimethylaminobenzoate, triethylamine, and triethanolamine) can be used. Titanocene compounds having absorption in the visible light region (for example, CGI-784 manufactured by BASF Japan) can also be added to a radical photopolymerization initiator in order to promote a photoreaction.

### <Thermosetting component>

The curable composition for inkjet of the present invention contains a block isocyanate compound as a thermosetting component. The addition of the thermosetting component together with the above photopolymerization to be cured the curable composition for inkjet with both light and heat further improves the heat resistance of a cured product obtained by the curable composition.

Examples of the thermosetting component include known thermosetting resins (for example, amino resins such as melamine resins, benzoguanamine resins, melamine resins, benzoguanamine resins, melamine derivatives, and benzoguanamine derivatives; block isocyanate compounds; cyclocarbonate compounds; thermosetting components having a cyclic (thio) ether group; bismaleimide; and carbodiimide resins). In the present invention, since a block isocyanate compound has an excellent storage stability, the block isocyanate compound is used.

The thermosetting component having cyclic (thio)ether groups in a molecule is a compound having in the molecule one or two types of groups selected from three-, four-, and five-membered cyclic (thio)ether groups. Examples of this compound include a compound having epoxy groups in the molecule (i.e., a polyfunctional epoxy compound), a compound having oxetanyl groups in the molecule (i.e., a polyfunctional oxetane compound), and a compound having thioether groups in the molecule (i.e., an episulfide resin).

Examples of the polyfunctional epoxy compound include, but are not limited to, epoxidized vegetable oils (for example, Adeka Cizer O-130P and Adeka Cizer O-180A manufactured by ADEKA Corporation); bisphenol A epoxy resins (for example, jER 828 manufactured by Mitsubishi Chemical Corporation, EHPE3150 manufactured by Daicel Chemical Industries, Ltd., Epicron 840 manufactured by DIC Corporation, Epotohto YD-011 manufactured by Tohto Kasei Co.,Ltd., D.E.R. 317 manufactured by Dow Chemical Company, Sumi-Epoxy ESA-011 manufactured by Sumitomo Chemical Industry Company Limited, and A.E.R. 330 manufactured by Asahi Kasei Corporation (all of which are trade names)); hydroquinone epoxy resins, bisphenol F epoxy resins (for example, YSLV-80XY manufactured by NIPPON STEEL Chemical & Material CO., LTD.), and thioether epoxy resins (for example, YSLV-120TE manufactured by NIPPON STEEL Chemical & Material CO., LTD.); brominated epoxy resins (for example, jER YL 903 manufactured by Mitsubishi Chemical Corporation, Epiclon 152 manufactured by DIC Corporation, Epotohto YDB-400 manufactured by Tohto Kasei Co.,Ltd., D.E.R. 542 manufactured by Dow Chemical Company, Sumi-Epoxy ESB-400 manufactured by Sumitomo Chemical Industry Company Limited, and A.E.R. 711 manufactured by Asahi Kasei Corporation (all of which are trade names)); novolak epoxy resins (for example, jER 152 manufactured by Mitsubishi Chemical Corporation, D.E.N. 431 manufactured by Dow Chemical Company, Epiclon N-730 manufactured by DIC Corporation, Epotohto YDCN-701 manufactured by Tohto Kasei Co., Ltd., EPPN-201 manufactured by Nippon Kayaku Co., Ltd., Sumi-Epoxy ESCN-195X manufactured by Sumitomo Chemical Industry Company Limited, and A.E.R. ECN-235 manufactured by Asahi Kasei Corporation (all of which are trade names)); biphenol novolak epoxy resins (for example, NC-3000 manufactured by Nippon Kayaku Co., Ltd.); bisphenol F epoxy resins (for example, Epiclon 830 manufactured by DIC Corporation, jER 807 manufactured by Mitsubishi Chemical Corporation, and Epotohto YDF-170, YDF-175, and YDF-2004 manufactured by Tohto Kasei Co., Ltd. (all of which are trade names)); hydrogenated bisphenol A epoxy resins (for example, Epotohto ST-2004 manufactured by Tohto Kasei Co., Ltd. (which is trade name)); glycidylamine epoxy resins (for example, jER 604 manufactured by Mitsubishi Chemical Corporation, Epotohto YH-434 manufactured by Tohto Kasei Co., Ltd., and Sumi-Epoxy ELM-120 manufactured by Sumitomo Chemical Industry Company Limited. (all of which are trade names)); hydantoin epoxy resins; alicyclic epoxy resins (for example, Celloxide 2021 manufactured by Daicel Chemical Industries, Ltd. (which is trade name)); trihydroxyphenyl methane epoxy resins (for example, EPPN-501 manufactured by Nippon Kayaku Co., Ltd. (which is trade name)); bixylenol or biphenol epoxy resins (for example, YL-6056, YX-4000, YL-6121 manufactured by Mitsubishi Chemical Corporation (all of which are trade names)) or mixtures thereof; bisphenol S epoxy resins (for example, EBPS-200 manufactured by Nippon Kayaku Co., Ltd., EPX-30 manufactured by ADEKA Corporation, and EXA-1514 manufactured by DIC Corporation (which is trade name)); bisphenol A novolak epoxy resins (for example, jER 157Smanufactured by Mitsubishi Chemical Corporation (which is trade name)); tetraphenylol ethane epoxy resins (for example, jER YL-931 manufactured by Mitsubishi Chemical Corporation (which is trade name) heterocyclic epoxy resins (for example, TEPIC manufactured by Nissan Chemical Industries, Ltd. (which is trade name)); diglycidyl phthalate resins (for example, BLEMMER DGT manufactured by NOF CORPORATION; tetraglycidylxylenoylethane resins such as ZX-1063 manufactured by Tohto Kasei Co., Ltd.); naphthalene group-containing epoxy resins (for example, ESN-190 manufactured by NIPPON STEEL Chemical and HP-4032 manufactured by DIC Corporation); epoxy resins having a dicyclopentadiene skeleton (for example, HP-7200 manufactured by DIC Corporation); glycidyl methacrylate copolymer-based epoxy resins (for example, CP-50S and CP-50M manufactured by NOF CORPORATION) ; moreover, copolymer epoxy resins of cyclohexyl maleimide and glycidyl methacrylate; and epoxy-modified polybutadiene rubber derivatives (for example, PB-3600 manufactured by Daicel Chemical Industries, Ltd.) and CTBN-modified epoxy resins (for example, YR-102 and YR-450 manufactured by Tohto Kasei Co., Ltd.). One of them may be used alone, or two or more thereof may be used in combination. Among them, in particular, novolac epoxy resins, bixylenol epoxy resins, biphenol epoxy resins, biphenol novolac epoxy resins, naphthalene epoxy resins, or mixtures thereof are preferable.

Examples of the polyfunctional oxetane compound include polyfunctional oxetanes (for example, bis[(3-methyl-3-oxetanylmethoxy)methyl] ether, bis[(3-ethyl-3-oxetanylmethoxy)methyl] ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methyl acrylate, (3-ethyl-3-oxetanyl)methyl acrylate, (3-methyl-3-oxetanyl)methyl methacrylate, (3-ethyl-3-oxetanyl)methyl methacrylate, oligomers thereof, or copolymers thereof; and etherified products between oxetane alcohol and a resin having a hydroxyl group (for example, a novolac resin, poly(p-hydroxystyrene), cardo bisphenol, calixarene, calixresorcinarene, or silsesquioxane). Another example is a copolymer of an unsaturated monomer having an oxetane ring and alkyl (meth)acrylate.

A monomer having in a molecule both a radically polymerizable moiety (a methacryl group) and a cationically polymerizable moiety (an oxetanyl moiety) (for example, (3-methyl-3-oxetanyl)methyl acrylate, (3-ethyl-3-oxetanyl)methyl acrylate, (3-methyl-3-oxetanyl)methyl methacrylate, or (3-ethyl-3-oxetanyl)methyl methacrylate) is both a photocurable component and a thermosetting component. Thus, the monomer is preferably contained in the composition when the two-step curing of photocuring and heat curing is performing.

Examples of such components include, for example, bisphenol A ethylene oxide-modified diacrylate (product name, DPGDA, manufactured by TOAGOSEI CO., LTD.), 4-hydroxybutyl acrylate glycidyl ether (product name, 4HBAGE, manufactured by Nihon Kasei Co., Ltd.), and 3,4-epoxycyclohexylmethyl methacrylate (product name, Cyclomer M100, manufactured by Daicel Corporation), other than the polyfunctional oxetane compounds.

Examples of the compound having cyclic thioether groups in the molecule include bisphenol A episulfide resin YL7000 manufactured by Mitsubishi Chemical Corporation. An episulfide resin, in which the oxygen atom of an epoxy group in a novolac epoxy resin is replaced with a sulfur atom using the same synthesis method, can also be used.

Examples of amino resins (for example, melamine derivatives and benzoguanamine derivatives) include a methylol melamine compound, a methylol benzoguanamine compound, a methylol glycoluril compound, and a methylolurea compound. Further, an alkoxymethylated melamine compound, an alkoxymethylated benzoguanamine compound, an alkoxymethylated glycoluril compound, and an alkoxymethylated urea compound can be obtained by converting the methylol group in each of the methylol melamine compound, the methylol benzoguanamine compound, the methylol glycoluril compound, and the methylolurea compound into an alkoxymethyl group. The kind of this alkoxymethyl group is not limited, but may be, for example, a methoxymethyl group, an ethoxymethyl group, a propoxymethyl group, a butoxymethyl group. In particular, a melamine derivative having a formalin concentration of 0.2% or less is preferable. This is because this melamine derivative is physically and environmentally friendly.

Examples of commercially available products thereof include Cymel 300, Cymel 301, Cymel 303, Cymel 370, Cymel 325, Cymel 327, Cymel 701, and Cymel 266 (all manufactured by Mitsui Cyanamid Ltd.), as well as Nikalac Mx-750, Nikalac Mx-032, Nikalac Mx-270, Nikalac Mx-280, Nikalac Mx-290, and Nikalac Mx-706 (all manufactured by SANWA Chemical Co., Ltd.) . One of these thermosetting components may be used alone, or two or more thereof may be used in combination.

An isocyanate compound or a block isocyanate compound is a compound having isocyanate groups or block isocyanate groups in one molecule. Examples of such compounds having isocyanate groups or block isocyanate groups in one molecule include polyisocyanate compounds and block isocyanate compounds. The block isocyanate group means a group obtainable by reacting an isocyanate group with a blocking agent. By this reaction, the isocyanate group is protected and temporarily deactivated. When the block isocyanate group is heated to a predetermined temperature, the blocking agent dissociates to produce an isocyanate group. The addition of the polyisocyanate compound or the block isocyanate compound can improve a hardenability and the toughness of an obtained cured product.

Examples of such a polyisocyanate compound include, for example, aromatic polyisocyanate, aliphatic polyisocyanate, and alicyclic polyisocyanate.

Concrete examples of the aromatic polyisocyanate include 4,4'-diphenylmethane diisocyanate, 2,4-tolylene diisocyanate, 2,6-tolylene diisocyanate, naphthalene-1,5-diisocyanate, o-xylylene diisocyanate, m-xylylene diisocyanate, and 2,4-tolylene dimer.

Concrete examples of the aliphatic polyisocyanate include tetramethylene diisocyanate, hexamethylene diisocyanate, methylene diisocyanate, trimethylhexamethylene diisocyanate, 4,4-methylenebis (cyclohexyl isocyanate), and isophorone diisocyanate.

Concrete examples of the alicyclic polyisocyanate include bicycloheptane triisocyanate. Further, examples thereof include adducts, burettes, and isocyanurates of the above-described isocyanate compounds.

Product obtained by addition reaction between an isocyanate compound and an isocyanate blocking agent is used as a block isocyanate compound. Examples of the isocyanate compound capable of reacting with the blocking agent include the polyisocyanate compounds described above.

Examples of the isocyanate blocking agent include phenol-based blocking agents (for example, phenol, cresol, xylenol, chlorophenol, and ethylphenol); lactam-based blocking agents (for example, ε-caprolactam, δ-valerolactam, γ-butyrolactam, and β-propiolactam); active methylene-based blocking agents (for example, ethyl acetoacetate and acetylacetone); alcohol-based blocking agents (for example, methanol, ethanol, propanol, butanol, amyl alcohol, ethylene glycol monomethyl ether, ethylene glycol monoethyl ether, ethylene glycol monobutyl ether, diethylene glycol monomethyl ether, propylene glycol monomethyl ether, benzyl ether, methyl glycolate, butyl glycolate, diacetone alcohol, methyl lactate, and ethyl lactate); oxime-based blocking agents (for example, formaldehyde oxime, acetaldoxime, acetoxime, methyl ethyl ketoxime, diacetyl monooxime, and cyclohexane oxime); mercaptan-based blocking agents (for example, butyl mercaptan, hexyl mercaptan, t-butyl mercaptan, thiophenol, methylthiophenol, and ethylthiophenol); acid amide-based blocking agents (for example, acetic acid amide and benzamide); imide-based blocking agents such as succinimide and maleic imide); amine-based blocking agents (for example, xylidine, aniline, butylamine, and dibutylamine); imidazole-based blocking agents (for example, imidazole and 2-ethylimidazole); imine-based blocking agents (for example, methyleneimine and propyleneimine).

Commercially available block isocyanate compounds may be used. Examples thereof include Sumidur BL-3175, BL-4165, BL-1100, and BL-1265, Desmodur TPLS-2957, TPLS-2062, TPLS-2078, and TPLS-2117, and Desmotherm 2170 and Desmotherm 2265 (all manufactured by Sumitomo Bayer Urethane Co., Ltd.), Coronate 2512, Coronate 2513, and Coronate 2520 (all manufactured by Nippon Polyurethane Industry Co., Ltd.), B-830, B-815, B-846, B-870, B-874, and B-882 (all manufactured by Mitsui Takeda Chemicals Inc.), TPA-B80E, 17B-60PX, and E402-B80T (all manufactured by Asahi Kasei Chemicals Corporation). Sumidur BL-3175 and BL-4265 are obtained by using methyl ethyl oxime as a blocking agent. One of such compounds having isocyanate groups or block isocyanate groups in one molecule may be used alone or two or more thereof may be used in combination.

The amount blended of the thermosetting component is preferably 1 to 30 parts by mass with respect to 100 parts by mass of the (meth) acrylate-containing monomer contained in the curable composition of the present invention. When the amount blended thereof is 1 part by mass or more, the toughness and the heat resistance of a coating film are further improved. When the amount blended thereof is 30 parts by mass or less, the deterioration of storage stability can be suppressed.

### <Hydroxy group-containing (meth)acrylate>

The curable composition for inkjet of the present invention contains a hydroxyl group-containing (meth)acrylate. The reaction of the hydroxyl group-containing (meth)acrylate with another component (in particular, a thermosetting component) improves the heat resistance of a cured composition after the composition is cured after the curable composition for inkjet is cured. The hydroxyl group-containing (meth) acrylate has at least one hydroxyl group and at least one acryloyl group or methacryloyl group.

Examples of the hydroxyl group-containing (meth)acrylate include 2-hydroxy-3-acryloyloxypropyl (meth)acrylate, 2-hydroxy-3-phenoxyethyl (meth)acrylate, 1,4-cyclohexanedimethanol mono(meth)acrylate, 2-hydroxyethyl (meth)acrylate, 2-hydroxypropyl (meth)acrylate, 4-hydroxybutyl (meth)acrylate, pentaerythritol tri(meth) acrylate, dipentaerythritol monohydroxy penta (meth) acrylate, and 2-hydroxypropyl (meth)acrylate.

Examples of commercially available products include Aronix M-5700 (trade name; manufactured by TOAGOSEI CO., LTD.), 4HBA, 2HEA, and CHDMMA (all of which are trade names; manufactured by Nihon Kasei Co., Ltd.), BHEA, HPA, HEMA, and HPMA (all of which are trade names; manufactured by NIPPON SHOKUBAI CO., LTD.), and LIGHT ESTER HO, LIGHT ESTER HOP, and LIGHT ESTER HOA (all of which are trade names; manufactured by Kyoeisha Chemical Co., Ltd.). One of these (meth)acrylate compounds having a hydroxy group may be used alone, or two or more thereof may be used in combination.

Among them, in particular, 2-hydroxy-3-acryloyloxypropyl acrylate, 2-hydroxy-3-phenoxyethyl acrylate, 2-hydroxyethyl acrylate, 2-hydroxypropyl acrylate, 4-hydroxybutyl acrylate, and 1,4-cyclohexanedimethanol monoacrylate are preferably used. A monofunctional (meth)acrylate compound is preferably used, for example, in order to easily adjust viscosity.

The amount blended of the hydroxyl group-containing (meth)acrylate compound is 1 to 30% by mass, more preferably 2 to 15% by mass, and even more preferably 3 to 10% by mass based on the total mass of the (meth)acryloyl group-containing monomer contained in the curable composition of the present invention.

### <Other (meth)acrylate compounds>

The curable composition for inkjet printing of the present invention may further contain, for example, a monofunctional or bifunctional (meth)acrylate compound other than the (meth)acrylate compounds described above. In general, a composition including a monofunctional (meth) acrylate compound and/or a bifunctional (meth)acrylate compound have an advantage in low viscosity, but have a disadvantage in a curing performance at surface point and a curing performance at deep point due to the small number of functional groups. However, the present invention includes the combination of the oxime ester-based photopolymerization initiator (A) and the amino group-containing (meth)acrylate compound (B). This result in low viscosity required in the use for inkjet as well as an excellent curing performance at surface point and an excellent curing performance at deep point.

Examples of the monofunctional (meth)acrylate include aliphatic (meth)acrylates (for example, methyl (meth)acrylate, ethyl (meth)acrylate, butyl (meth)acrylate, hydroxyethyl (meth)acrylate, 4-hydroxybutyl (meth)acrylate, hydroxypropyl (meth)acrylate, butoxymethyl (meth)acrylate, 2-ethylhexyl (meth)acrylate, lauryl (meth)acrylate, isodecyl (meth)acrylate, and glycerol mono(meth)acrylate); alicyclic (meth)acrylates (for example, cyclohexyl (meth)acrylate, 4-(meth)acryloxytricyclo [5.2.1.02,6] decane, and isobornyl (meth)acrylate); aromatic (meth)acrylates (for example, phenoxyethyl (meth)acrylate, benzyl (meth)acrylate, phenyl (meth)acrylate, and 2-hydroxy-3-phenoxypropyl (meth)acrylate); modified (meth)acrylates (for example, aliphatic epoxy-modified (meth)acrylate); tetrahydrofurfuryl (meth)acrylate, 2-(meth)acryloxyalkyl phosphate, 2-(meth)acryloyloxyethyl phosphoric acid ester, (meth)acryloyloxyethyl phthalic acid, and γ-(meth)acryloxyalkyltrialkoxysilane.

When the monofunctional (meth) acrylate is used, the content thereof is, for example, 1 to 99% by mass, preferably 1 to 50% by mass, more preferably 1 to 30% by mass, even more preferably 1 to 10% by mass, and particularly preferably 2 to 8% by mass based on the total mass of the (meth)acryloyl group-containing monomer contained in the curable composition for inkjet printing of the present invention.

Concrete examples of the bifunctional (meth)acrylate include diol diacrylates (for example, 1,4-butanediol diacrylate, 1,6-hexanediol diacrylate, 1,9-nonanediol diacrylate, and 1,10-decanediol diacrylate); glycol diacrylates (for example, ethylene glycol diacrylate, diethylene glycol diacrylate, triethylene glycol diacrylate, tetraethylene glycol diacrylate, polyethylene glycol diacrylate, dipropylene glycol diacrylate, tripropylene glycol diacrylate, polypropylene glycol diacrylate, neopentyl glycol diacrylate, diacrylates of diols obtained by adding at least any one of ethylene oxide and propylene oxide to neopentyl glycol, and caprolactone-modified neopentyl glycol hydroxypivalate diacrylate); and diacrylates having a cyclic structure (for example, bisphenol A-EO adduct diacrylate, bisphenol A-PO adduct diacrylate, tricyclodecane dimethanol diacrylate, hydrogenated dicyclopentadienyl diacrylate, and cyclohexyl diacrylate).

Examples of commercially available products include Light Acrylate 1, 6HX-A, 1,9ND-A, 3EG-A, and 4EG-A (trade name; manufactured by Kyoeisha Chemical Co., Ltd.), HDDA, 1,9-NDA, DPGDA, and TPGDA (trade name; manufactured by Daicel Cytec Co., Ltd.), Viscoat #195, #230, #230D, #260, #310HP, #335HP, and #700HV (trade name; manufactured by Osaka Organic Chemical Industry Ltd.), and Aronix M-208, M-211B, M-220, M-225, M-240, and M-270 (trade name; manufactured by TOAGOSEI CO., LTD.).

When the bifunctional (meth)acrylate is used, the content thereof is, for example, 1 to 99% by mass, preferably 10 to 90% by mass, and more preferably 20 to 85% by mass based on the total mass of the (meth)acryloyl group-containing monomer contained in the curable composition for inkjet printing of the present invention.

### <Other components>

The curable resin composition of the present invention can contain additives (for example, antifoaming/leveling agents, thixotropy-imparting agents/thickeners, coupling agents, dispersants, flame retardants, and polymerization initiation aids), if necessary.

Compounds (for example, silicone, modified silicone, mineral oil, vegetable oil, fatty alcohol, fatty acid, metal soap, fatty acid amide, polyoxyalkylene glycol, polyoxyalkylene alkyl ether, and polyoxyalkylene fatty acid ester) can be used as antifoaming agents/leveling agents.

Clay minerals (for example, kaolinite, smectite, montmorillonite, bentonite, talc, mica, and zeolite, fine particle silica, silica gel, amorphous inorganic particles, polyamide-based additives, modified urea-based additives, and wax-based additives) can be used as thixotropy-imparting agents/thickeners.

The addition of an antifoaming /leveling agent and a thixotropy-imparting agent/thickener can adjust the surface properties of a cured product and the properties of a composition.

Coupling agents have an alkoxy group (for example, an ethoxy group, acetyl) and a reactive functional group (for example, vinyl, methacryl, acryl, epoxy, cyclic epoxy, mercapto, amino, diamino, acid anhydride, ureido, sulfide, isocyanate). For example, silane coupling agents, titanate-based coupling agents, titanate-based coupling agents, zirconate-based coupling agents, or aluminate-based coupling agents can be used. The silane coupling agents include, for example, vinyl-based silane compounds (for example, vinyl ethoxysilane, vinyl trimethoxysilane, vinyl·tris(β-methoxyethoxy) silane, and γ-methacryloxypropyltrimethoxysilane); amino-based silane compounds (for example, γ-aminopropyltrimethoxysilane, N-β-(aminoethyl)-γ-aminopropyltrimethoxysilane, N-β-(aminoethyl)-γ-aminopropylmethyldimethoxysilane, and γ-ureidopropyltriethoxysilane); epoxy-based silane compounds (for example, γ-glycidoxypropyltrimethoxysilane, β-(3,4-epoxycyclohexyl)ethyltrimethoxysilane, and γ-glycidoxypropylmethyldiethoxysilane); mercapto-based silane compounds (for example, γ-mercaptopropyltrimethoxysilane), and phenylamino-based silane compounds (for example, N-phenyl-γ-aminopropyltrimethoxysilane). The titanate-based coupling agents include, for example, isopropyl triisostearoylated titanate, tetraoctyl bis(ditridecyl phosphite) titanate, bis(dioctyl pyrophosphate) oxyacetate titanate, isopropyl tridodecylbenzenesulfonyl titanate, isopropyl tris(dioctyl pyrophosphate) titanate, tetraisopropyl bis(dioctyl phosphite) titanate, tetra(1,1-diallyloxymethyl-1-butyl) bis(ditridecyl) phosphite titanate, bis(dioctyl pyrophosphate) ethylene titanate, isopropyl trioctanoyl titanate, isopropyl dimethacryl isostearoyl titanate, isopropyl tristearoyl diacrylic titanate, isopropyl tri(dioctyl phosphate) titanate, isopropyl tricumyl phenyl titanate, dicumylphenyloxyacetate titanate, and diisostearoyl ethylene titanate. The zirconate-based coupling agents include, for example, ethylenically unsaturated zirconate-containing compounds, neoalkoxy zirconate-containing compounds, neoalkoxy trisneodecanoyl zirconate, neoalkoxy tris(dodecyl)benzenesulfonyl zirconate, neoalkoxy tris(dioctyl)phosphate zirconate, neoalkoxy tris(dioctyl)pyrophosphate zirconate, neoalkoxy tris(ethylenediamino)ethyl zirconate, neoalkoxy tris(m-amino)phenyl zirconate, tetra(2,2-diallyloxymethyl)butyl, di(ditridecyl)phosphite zirconate, neopentyl(diallyl)oxy, trineodecanoyl zirconate, neopentyl(diallyl)oxy, tri(dodecyl)benzene-sulfonyl zirconate, neopentyl(diallyl)oxy, tri(dioctyl)phosphato zirconate, neopentyl(diallyl)oxy, tri(dioctyl)pyro-phosphato zirconate, neopentyl(diallyl)oxy, tri(N-ethylenediamino)ethyl zirconate, neopentyl(diallyl)oxy, tri(m-amino)phenyl zirconate, neopentyl(diallyl)oxy, trimethacryl zirconate(, neopentyl(diallyl)oxy, triacryl zirconate, dineopentyl(diallyl)oxy, diparaaminobenzoyl zirconate, dineopentyl(diallyl)oxy, di(3-mercapto)propionic zirconate, zirconium (IV) 2,2-bis(2-propenolatomethyl)butanolato, cyclodi[2,2-(bis2-propenolatomethyl)butanolato]pyrophosphato-0,0. The aluminate-based coupling agents include, for example, diisobutyl(oleyl)acetoacetylaluminate and alkyl acetoacetate aluminum diisopropylate.

As dispersants, low-molecular weight dispersants (for example, polycarboxylic acid-based, naphthalene sulfonic acid formalin condensation-based, polyethylene glycol, polycarboxylic acid partial alkyl ester-based, polyether-based, and polyalkylene polyamine-based dispersants, and low-molecular dispersants such as alkyl sulfonic acid-based, quaternary ammonium-based, higher alcohol alkylene oxide-based, polyhydric alcohol ester-based, and alkyl polyamine-based dispersants) can be used.

As flame retardants, for example, hydrated metal-based flame retardants (for example, aluminum hydroxide and magnesium hydroxide), red phosphorus, ammonium phosphate, ammonium carbonate, zinc borate, zinc stannate, molybdenum compound-based flame retardants, bromine compound-based flame retardants, chlorine compound-based flame retardants, phosphoric acid ester, phosphorus-containing polyol, phosphorus-containing amine, melamine cyanurate, melamine compound, triazine compound, guanidine compound, silicone polymer flame retardants can be used.

A polymerization inhibitor and a polymerization retarder can be further added to adjust the polymerization rate and the degree of polymerization.

2, 4-Dimethylthioxanthone can be used as a polymerization initiation aid. The content thereof is usually 0.1 to 5 parts by mass, preferably 0.5 to 2 parts by mass with respect to 100 parts by mass of the (meth)acryloyl group-containing monomer contained in the curable composition of the present invention.

Further, a solvent may be used in the curable resin composition of the present invention in order to adjust viscosity. The amount of the solvent added is preferably small to prevent a film thickness after curing from decreasing. More preferably, a solvent for adjusting viscosity is not contained in the curable resin composition.

Color pigments and dyes may be added to the curable resin composition of the present invention for the purpose of coloring. Color indexes, which are known and commonly used, can be used in the color pigments and dyes. Examples include Pigment Blue 15, 15:1, 15:2, 15:3, 15:4, 15: 6, 16, 60, Solvent Blue 35, 63, 68, 70, 83, 87, 94, 97, 122, 136, 67, 70, Pigment Green 7, 36, 3, 5, 20, 28, Solvent Yellow 163, Pigment Yellow 24, 108, 193, 147, 199, 202, 110, 109, 139 179 185 93, 94, 95, 128, 155, 166, 180, 120, 151, 154, 156, 175, 181, 1, 2, 3, 4, 5, 6, 9, 10, 12, 61, 62, 62:1, 65, 73, 74, 75, 97, 100, 104, 105, 111, 116, 167, 168, 169, 182, 183, 12, 13, 14, 16, 17, 55, 63, 81, 83, 87, 126, 127, 152, 170, 172, 174, 176, 188, 198, Pigment Orange 1, 5, 13, 14, 16, 17, 24, 34, 36, 38, 40, 43, 46, 49, 51, 61, 63, 64, 71, 73, Pigment Red 1, 2, 3, 4, 5, 6, 8, 9, 12, 14, 15, 16, 17, 21, 22, 23, 31, 32, 112, 114, 146, 147, 151, 170, 184, 187, 188, 193, 210, 245, 253, 258, 266, 267, 268, 269, 37, 38, 41, 48:1, 48:2, 48:3, 48:4, 49:1, 49:2, 50:1, 52:1, 52:2, 53:1, 53:2, 57:1, 58:4, 63:1, 63:2, 64:1, 68, 171, 175, 176, 185, 208, 123, 149, 166, 178, 179, 190, 194, 224, 254, 255, 264, 270, 272, 220, 144, 166, 214, 220, 221, 242, 168, 177, 216, 122, 202, 206, 207, 209, Solvent Red 135, 179, 149, 150, 52, 207, Pigment Violet 19, 23, 29, 32, 36, 38, 42, Solvent Violet 13, 36, Pigment Brown 23, 25, and Pigment Black 1, 7. These color pigments and dyes are preferably added in an amount of 0.01 to 5% by mass based on the total mass of the curable composition.

Further, the curable composition of the present invention may contain rutile type or anatase type titanium oxide in order to improve the light reflectance of the LED. In this case, the rutile type or anatase type titanium oxide is preferably added in an amount of 1 to 20% by mass based on 100% by mass of the curable composition. These color pigments and dyes can be used alone or in combination of two or more kinds.

The curable composition of the present invention can be applied to printing by an inkjet method. In order for the curable composition to be applied to printing by the inkjet method, the curable composition preferably has a viscosity for discharging the composition by an inkjet printer.

Viscosity means viscosity measured according to JIS Z8803. The viscosity of the curable composition for inkjet is preferably 150 mPa·s or less at normal temperature (25°C). As described above, the viscosity of ink used in the inkjet printer is preferably about 20 mPa·s or less at the temperature of application. However, if the viscosity is 150 mPa·s or less at normal temperature, the above conditions can be satisfied by heating before or during application. The condition of viscosity is checked.

Therefore, a pattern can be directly printed onto a printed wiring board substrate or the like using the curable composition of the present invention.

Further, the curable composition of the present invention does not bring about a polymerization reaction at normal temperature. Thus, the curable composition of the present invention can be stably stored as a one-part curable composition.

The curable composition of the present invention is used as an ink in an inkjet printer and is used for printing on a substrate.

Since the curable composition of the present invention contains a photopolymerization initiator, a composition layer can be photocured by irradiating the composition layer with light between 50 mJ/cm² and 1000 mJ/cm² immediately after being printed. The light irradiation is carried out by irradiation of active energy rays (for example, ultraviolet rays, electron beams, and actinic rays), preferably by irradiation of ultraviolet rays.

Ultraviolet irradiation in an inkjet printer can be performed, for example, by attaching a light source (for example, a high-pressure mercury lamp, a metal halide lamp, or an ultraviolet LED) to the side surface of a print head, and then by operating with moving the print head or a substrate. In this case, printing and ultraviolet irradiation can be performed almost simultaneously.

When the curable composition after being photocured contains a thermosetting component, the curable composition is thermally cured by using a known heating means (for example, a heating oven such as a hot air oven, an electric oven, or an infrared induction heating oven). In a heating condition, heating is preferably carried out at 130° C. to 170° C. for 5 minutes to 90 minutes.

When a coating film, which is formed by the curable composition and which is pattern-printed onto a base material such as a substrate, is used as a solder resist, the coating film is heated in a soldering process for mounting a component. The soldering may be performed by any of manual soldering, flow soldering, reflow soldering, and the like. The coating film is subjected to a reflowing process, for example, in the case of reflow soldering. In the reflow soldering, preheating at 100°C to 140°C for 1 to 4 hours and then heating at 240 to 280°C for about 5 to 20 seconds are repeated several times (for example, 2 to 4 times) and thereby solder is heated and melted.

When the substrate is a so-called rigid substrate (that is, a double-sided board in which wiring is printed on both surfaces, or a multilayer board in which substrates is laminated), a substrate that has a coating film formed by the above curable composition is subjected to the above soldering process several times, and thereby the substrate is repetitively heated.

However, according to the curable resin composition of the present invention, an obtained coating film does not produce cracks in the coating film even after the film is subjected to heating in which the soldering can be carried out several times, and further the film maintains sufficient adhesion to a substrate and the hardness of coating film. Thus, the obtained coating film has good mechanical properties, and thereby the film is expected to be used as a solder resist applied on a rigid substrate.

The curable composition of the present invention has an excellent curing performance at surface point, an excellent curing performance at deep point, and heat resistance. Thus, the curable composition of the present invention is applicable to various applications. That is, the application targets are not particularly limited. The curable composition is preferably used, for example, in a solder resist and a marking for printed wiring boards.

As described above, the present invention also provides a cured product obtained by curing the curable composition for inkjet printing of the present invention, and an electronic component having the cured product. The use of the curable composition for inkjet printing of the present invention can provide an electronic component having high quality, high durability, and high reliability. The electronic component in the present invention means a component for using an electronic circuit. The electronic component includes passive components (for example, resistors, capacitors, inductors, and connectors), and active components (for example, printed wiring boards, transistors, light emitting diodes, and laser diodes).
Even when the cured product obtained by the curable composition of the present invention is used as these cured coating film for an insulating property, the cured coating film exhibits the effects of the present invention.

The present invention is not limited to the configurations of the above embodiments and Examples, and various modifications can be made within the scope of the invention.

### Examples

The present invention will be explained hereinafter with reference to Examples.

### <Preparation of compositions>

All of each component were blended in the proportions (unit: parts by mass) shown in Table 1, and the whole was stirred by a dissolver. Thereafter, the whole was dispersed for 2 hours by a bead mill using 1 mm zirconia beads to obtain compositions according to the present invention (Examples 1 to 3), a reference composition (Reference Example 4) and comparative compositions (Comparative Examples 1 to 4).

### <Evaluations>

### (1) Curing performance at deep point

The above compositions were applied to an FR-4 substrate using a 60 µm applicator (manufactured by ERICHSEN), and then cured with LED 365 nm (FE400 manufactured by Phoseon Technology) at 600 mJ/cm². Thereafter, heat treatment was performed for 60 minutes in a hot air circulation-type drying furnace at 150°C. A cross-cut tape peeling test (JIS K 5600) was performed on the prepared samples. The test results were shown as ○ when peeling did not occur. The test results were shown as × when peeling occurred.

### (2) Tack

The above compositions were applied to copper foil using a 60 µm applicator (manufactured by ERICHSEN), and then cured with LED 365 nm (FE400 manufactured by Phoseon Technology) at 600 mJ/cm². Thereafter, heat treatment was performed for 60 minutes in a hot air circulation-type drying furnace at 150°C. The prepared samples were evaluated by a tack-free performance. The test results were shown as ○ when the samples did not have tack properties. The test results were shown as × when the samples did not cure and remained liquid.

### (3) Heat resistance

The above compositions were applied to copper foil using a 60 µm applicator (manufactured by ERICHSEN), and then cured with LED 365 nm (FE400 manufactured by Phoseon Technology) at 600 mJ/cm². Thereafter, heat treatment was performed for 60 minutes in a hot air circulation-type drying furnace at 150°C. A peeling test was performed using a cellophane adhesive tape on the prepared samples according to the method of JIS C-5012. In the peeling test, the prepared samples were immersed in a solder bath at 260°C for 10 seconds. The state of a coating film after the peeling test was visually observed and evaluated according to the following criteria. The test results were shown as ○ when no change was observed in the coating film. The test results were shown as × when peeling was observed in the coating film.

### (4) Bleeding

The above compositions were applied to copper foil using a 60 µm applicator (manufactured by ERICHSEN), and then cured with LED 365 nm (FE400 manufactured by Phoseon Technology) at 600 mJ/cm². Thereafter, bleeding from the edge of a coating film was observed through an optical microscope, and then the bleeding was evaluated according to the following criteria. The test results were shown as ○ when no bleeding from the edge of a coating film was observed. The test results were shown as × when bleeding from the edge of a coating film was observed.

**[Table 1]**

| Component | Abbreviation | Example | | | | Comparative Example | | | |
|---|---|---|---|---|---|---|---|---|---|
| | | 1 | 2 | 3 | 4* | 1 | 2 | 3 | 4 |
| Thermosetting component | 7982 | 10 | 10 | 10 | 10 | 10 | 10 | 10 | 10 |
| Hydroxyl group-containing (meth)acrylate | 4-HBA | 5 | - | 5 | 5 | - | 5 | 5 | - |
| Hydroxyl group-containing (meth)acrylate | CHDMMA | - | 5 | - | - | - | - | - | - |
| Amino group-containing (meth)acrylate | DM-281 | 5 | 5 | - | 5 | 5 | - | 5 | - |
| Amino group-containing (meth)acrylate | CN371NS | - | - | 5 | - | - | - | - | - |
| Bifunctional (meth)acrylate | DPGDA | 70 | 70 | 70 | 70 | 70 | 70 | 70 | 70 |
| Monofunctional (meth)acrylate | M-221B | 15 | 15 | 15 | 15 | 15 | 15 | 15 | 15 |
| Monofunctional (meth)acrylate | POA | 5 | 5 | 5 | 5 | 5 | 5 | 5 | 5 |
| Aminoacetophenone-based photopolymerization initiator | Omnirad379 | 8 | 8 | 8 | 8 | 8 | 8 | 8 | 8 |
| Thioxanthone-based photopolymerization initiator | DETX | 1 | 1 | 1 | 1 | 1 | 1 | 1 | 1 |
| Oxime ester-based photopolymerization initiator | TOE-04-A3 | 0.5 | 0.5 | 0.5 | - | 0.5 | 0.5 | - | - |
| Oxime ester-based photopolymerization initiator | OXE-02 | - | - | - | 2 | - | - | - | - |
| Carbon black | MA-100 | 1 | 1 | 1 | 1 | 1 | 1 | 1 | 1 |
| Silicone-based additive | BYK-307 | 0.1 | 0.1 | 0.1 | 0.1 | 0.1 | 0.1 | 0.1 | 0.1 |
| Curing performance at deep point | | ○ | ○ | ○ | ○ | ○ | ○ | × | × |
| Tack | | ○ | ○ | ○ | ○ | ○ | × | ○ | × |
| Heat resistance | | ○ | ○ | ○ | ○ | × | ○ | ○ | × |
| Bleeding | | ○ | ○ | ○ | ○ | ○ | × | ○ | × |

| | | | | | | | | | |
|---|---|---|---|---|---|---|---|---|---|
| * Reference Example | | | | | | | | | |

Each component in Table 1 is detailed as follows.
7982: Block isocyanate (manufactured by Baxenden Chemicals Ltd.)
4-HBA: 4-Hydroxybutyl acrylate (manufactured by Nihon Kasei Co., Ltd.)
CHDMMA: 1,4-Cyclohexanedimethanol monoacrylate (manufactured by Nihon Kasei Co., Ltd.)
DM-281: Amine-modified polyfunctional polyester acrylate (manufactured by DOUBLE BOND CHEMICAL IND. CO., LTD.)
CN371NS: Bifunctional amino acrylate (manufactured by ARKEMA)
DPGDA: Dipropylene glycol diacrylate (manufactured by BASF Japan)
M-221B: EO-modified bisphenol-A diacrylate (manufactured by TOAGOSEI CO., LTD.)
POA: Phenoxyethyl acrylate (Kyoeisha Chemical Co., Ltd.)
Omnirad 379:
   Benzyl-2-dimethylamino-1-(4-morpholinophenyl)-butanone (manufactured by IGM Resins)
DETX: 2,4-Dimethyl thioxanthone (manufactured by Nippon Kayaku Co., Ltd.)
TOE-04-A3: Oxime ester photopolymerization initiator (manufactured by Nippon Chemical Works Co., Ltd.)
OXE-02: Ethanone,
   1-[9-ethyl-6-(2-methylbenzoyl)-9H-carbazole-3-yl]-,
   1-(0-acetyloxime) (manufactured by BASF)
MA-100: Carbon black (manufactured by Mitsubishi Chemical Corporation)
BYK-307: Silicone-based additive (manufactured by BYK Japan KK)

### <Evaluation results>

Examples 1 to 3 and Reference Example 4 exhibited good results in all of a curing performance at deep point, a curing performance at surface point (tack, bleeding), and a heat resistance. In contrast, Comparative Example 1, in which no hydroxyl group-containing acrylate is contained in the comparative composition, had poor heat resistance. Comparative Example 2, in which no amino group-containing acrylate is contained in the comparative composition, had a poor curing performance at surface point (tack and bleeding). Comparative Example 3, in which no oxime ester-based photopolymerization initiator is used in the comparative composition, had a poor curing performance at deep point. Comparative Example 4, in which none of the hydroxyl group-containing acrylate, amino group-containing acrylate, and oxime ester-based photopolymerization initiator are contained in the comparative composition, had poor evaluations in all of a curing performance at deep point, a curing performance at surface point (tack, bleeding), and a heat resistance.

## Claims

1. A curable composition for inkjet, comprising:
(A) an oxime ester-based photopolymerization initiator;
(B) an amino group-containing (meth)acrylate compound;
an aminoacetophenone-based photopolymerization initiator;
a hydroxyl group-containing (meth)acrylate; and
a block isocyanate compound,
wherein said (A) oxime ester-based photopolymerization initiator is an oxime ester compound having a carbazole structure represented by the following general formula (I): 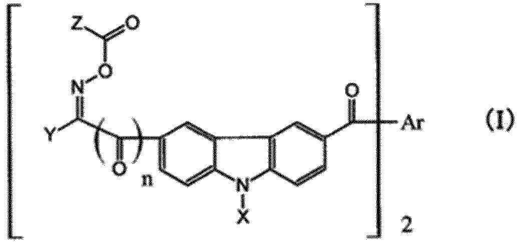
wherein X represents a hydrogen atom, an alkyl group having 1 to 17 carbon atoms, an alkoxy group having 1 to 8 carbon atoms, a phenyl group which may have a substituent selected from an alkyl group having 1 to 17 carbon atoms, an alkoxy group having 1 to 8 carbon atoms, an amino group, and an alkylamino or dialkylamino group in which the alkyl moiety has 1 to 8 carbon atoms, or a naphthyl group which may have a substituent selected from an alkyl group having 1 to 17 carbon atoms, an alkoxy group having 1 to 8 carbon atoms, an amino group, and an alkylamino group or dialkylamino group in which the alkyl moiety has 1 to 8 carbon atoms;
each of the Y and Z represents a hydrogen atom, an alkyl group having 1 to 17 carbon atoms, an alkoxy group having 1 to 8 carbon atoms, a halogen group, a phenyl group which may have a substituent selected from an alkyl group having 1 to 17 carbon atoms, an alkoxy group having 1 to 8 carbon atoms, an amino group, and an alkylamino or dialkylamino group in which the alkyl moiety has 1 to 8 carbon atoms, a naphthyl group which may have a substituent selected from an alkyl group having 1 to 17 carbon atoms, an alkoxy group having 1 to 8 carbon atoms, an amino group, and an alkylamino or dialkylamino group in which the alkyl moiety has 1 to 8 carbon atoms, an anthryl group, a pyridyl group, a benzofuryl group, or a benzothienyl group;
Ar represents alkylene having 1 to 10 carbon atoms, vinylene, phenylene, biphenylene, pyridylene, naphthylene, thiophene, anthrylene, thienylene, furylene, 2,5-pyrrol-diyl, 4,4'-stilben-diyl, or 4,2'-styren-diyl; and
n is an integer of 0 or 1.

2. A cured product obtained by curing the curable composition for inkjet according to claim 1.

3. An electronic component comprising the cured product according to claim 2.

## Patentansprüche

1. Härtbare Zusammensetzung für den Tintenstrahl, umfassend:
(A) einen Photopolymerisationsinitiator auf Oximesterbasis,
(B) eine aminogruppenhaltige (Meth)acrylatverbindung,
einen Photopolymerisationsinitiator auf Aminoacetophenonbasis,
ein hydroxylgruppenhaltiges (Meth)acrylat und
eine Bockisocyanatverbindung,
wobei der (A) Photopolymerisationsinitiator auf Oximesterbasis eine Oximesterverbindung mit einer Carbazolstruktur, dargestellt durch die folgende allgemeine Formel (I), ist: 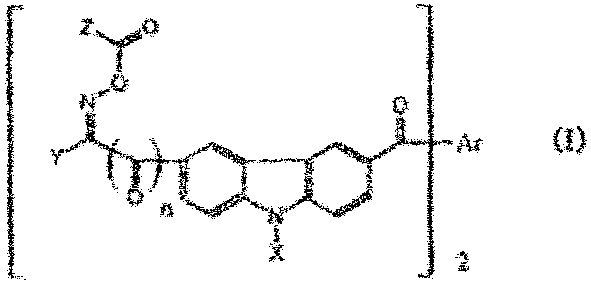
worin X ein Wasserstoffatom, eine Alkylgruppe mit 1 bis 17 Kohlenstoffatomen, eine Alkoxygruppe mit 1 bis 8 Kohlenstoffatomen, eine Phenylgruppe, die einen Substituenten aufweisen kann, der aus einer Alkylgruppe mit 1 bis 17 Kohlenstoffatomen, einer Alkoxygruppe mit 1 bis 8 Kohlenstoffatomen, einer Aminogruppe und einer Alkylamino- oder Dialkylaminogruppe, in der der Alkylrest 1 bis 8 Kohlenstoffatome aufweist, ausgewählt ist, oder eine Naphthylgruppe, die einen Substituenten aufweisen kann, der aus einer Alkylgruppe mit 1 bis 17 Kohlenstoffatomen, einer Alkoxygruppe mit 1 bis 8 Kohlenstoffatomen, einer Aminogruppe und einer Alkylaminogruppe oder Dialkylaminogruppe, in der der Alkylrest 1 bis 8 Kohlenstoffatome aufweist, ausgewählt ist, darstellt,
jedes Y und Z ein Wasserstoffatom, eine Alkylgruppe mit 1 bis 17 Kohlenstoffatomen, eine Alkoxygruppe mit 1 bis 8 Kohlenstoffatomen, eine Halogengruppe, eine Phenylgruppe, die einen Substituenten aufweisen kann, der aus einer Alkylgruppe mit 1 bis 17 Kohlenstoffatomen, einer Alkoxygruppe mit 1 bis 8 Kohlenstoffatomen, einer Aminogruppe und einer Alkylaminogruppe oder Dialkylaminogruppe, in der der Alkylrest 1 bis 8 Kohlenstoffatome aufweist, ausgewählt ist, eine Naphthylgruppe, die einen Substituenten aufweisen kann, der aus der Gruppe, bestehend aus einer Alkylgruppe mit 1 bis 17 Kohlenstoffatomen, einer Alkoxygruppe mit 1 bis 8 Kohlenstoffatomen, einer Aminogruppe und einer Alkylamino oder Dialkylaminogruppe, in der der Alkylrest 1 bis 8 Kohlenstoffatome aufweist, ausgewählt ist, eine Anthrylgruppe, eine Pyridylgruppe, eine Benzofurylgruppe oder eine Benzothienylgruppe darstellen,
Ar ein Alkylen mit 1 bis 10 Kohlenstoffatomen, Vinylen, Phenylen, Biphenylen, Pydridylen, Naphthylen, Thiophen, Anthrylen, Thienylen, Furylen, 2,5-Pyrroldiyl, 4,4'-Stilbendiyl oder 4,2'-Styroldiyl darstellt und
n eine ganze Zahl von 0 oder 1 ist.

2. Gehärtetes Produkt, das durch Härten der härtbaren Zusammensetzung für den Tintenstrahl gemäß Anspruch 1 erhalten wird.

3. Elektronisches Bauteil, umfassend das gehärtete Produkt gemäß Anspruch 2.

## Revendications

1. Composition durcissable pour jet d'encre, comprenant :
(A) un initiateur de photopolymérisation à base d'ester d'oxime ;
(B) un composé (méth)acrylate contenant un groupe amino ;
un initiateur de photopolymérisation à base d'aminoacétophénone ;
un (méth)acrylate contenant un groupe hydroxyle ; et
un composé d'isocyanate bloqué,
dans laquelle ledit initiateur de photopolymérisation à base d'ester d'oxime (A) est un composé d'ester d'oxime présentant une structure carbazole représentée par la formule générale suivante (I) : 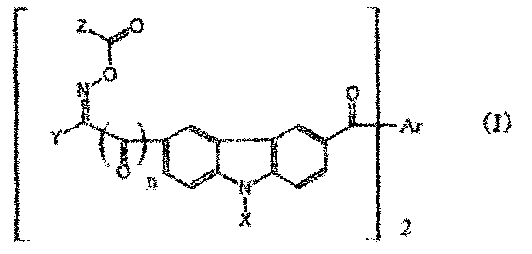
dans laquelle X représente un atome d'hydrogène, un groupe alkyle présentant de 1 à 17 atomes de carbone, un groupe alcoxy présentant de 1 à 8 atomes de carbone, un groupe phényle qui peut présenter un substituant choisi dans un groupe alkyle présentant de 1 à 17 atomes de carbone, un groupe alcoxy présentant de 1 à 8 atomes de carbone, un groupe amino, et un groupe alkylamino ou dialkylamino dans lesquels le fragment alkyle présente de 1 à 8 atomes de carbone, ou un groupe naphtyle qui peut présenter un substituant choisi dans un groupe alkyle présentant de 1 à 17 atomes de carbone, un groupe alcoxy présentant de 1 à 8 atomes de carbone, un groupe amino, et un groupe alkylamino ou un groupe dialkylamino dans lesquels le fragment alkyle présente de 1 à 8 atomes de carbone ;
chacun de Y et Z représente un atome d'hydrogène, un groupe alkyle présentant de 1 à 17 atomes de carbone, un groupe alcoxy présentant de 1 à 8 atomes de carbone, un groupe halogène, un groupe phényle qui peut présenter un substituant choisi dans un groupe alkyle présentant de 1 à 17 atomes de carbone, un groupe alcoxy présentant de 1 à 8 atomes de carbone, un groupe amino, et un groupe alkylamino ou dialkylamino dans lesquels le fragment alkyle présente de 1 à 8 atomes de carbone, un groupe naphtyle qui peut présenter un substituant choisi dans un groupe alkyle présentant de 1 à 17 atomes de carbone, un groupe alcoxy présentant de 1 à 8 atomes de carbone, un groupe amino, et un groupe alkylamino ou dialkylamino dans lesquels le fragment alkyle présente de 1 à 8 atomes de carbone, un groupe anthryle, un groupe pyridyle, un groupe benzofuryle, ou un groupe benzothiényle ;
Ar représente un alkylène présentant de 1 à 10 atomes de carbone, un vinylène, un phénylène, un biphénylène, un pyridylène, un naphtalène, un thiophène, un anthrylène, un thiénylène, un furylène, du 2,5-pyrrole-diyl, du 4,4'-stilbène-diyl, ou du 4,2'-styrène-diyl ; et
n est un nombre entier égal à 0 ou 1.

2. Produit durci obtenu par le durcissement de la composition durcissable pour jet d'encre selon la revendication 1.

3. Composant électronique comprenant le produit durci selon la revendication 2.
